# EUROPÄISCHE PATENTSCHRIFT

(11) **EP 3 233 414 B1**
(45) Veröffentlichungstag und Bekanntmachung des Hinweises auf die Patenterteilung: **08.01.2020**
(21) Anmeldenummer: 15832880.7
(22) Anmeldetag: 09.12.2015
(51) Int. Cl.: B29C 45/76

(54) **VERFAHREN UND VORRICHTUNG ZUM VERGUSS VON IN EINER VERGUSSMASSE VERGOSSENEN LED-LEUCHTE**
METHOD AND DEVICE FOR POTTING AN LED LUMINAIRE POTTED IN A POTTING COMPOUND
PROCÉDÉ ET DISPOSITIF D'ENROBAGE DE LAMPE À LED DANS UNE MATIÈRE D'ENROBAGE

(30) Priorität: 15.12.2014 DE 102014118671; 15.12.2014 DE 102014118672
(43) Veröffentlichungstag der Anmeldung: 25.10.2017
(73) Patentinhaber: Geomar Helmholtz-Zentrum für Ozeanforschung Kiel, 24148 Kiel (DE)
(72) Erfinder: STICKLUS, Jan, 24340 Eckernförde (DE); KWASNITSCHKA, Tom, 24114 Kiel (DE); HÖHER, Peter, Adam, 24226 Heikendorf (DE)
(74) Vertreter: Hansen, Jochen
(86) Internationale Anmeldenummer: PCT/DE2015/100529
(87) Internationale Veröffentlichungsnummer: WO 2016/095901

(56) Entgegenhaltungen:
- WO-A1-2008/052667
- US-A1- 2013 021 811

## Beschreibung

Die Erfindung betrifft ein LED-Leuchte-Vergussverfahren mit den Schritten: Einbringen einer konfigurierten und mit einer optisch-transparenten Vergussmasse zu vergießenden Leuchte in eine wenigstens teilweise optisch-transparente Vergussform, wobei die Vergussform in einer Vakuumkammer angeordnet ist und die Leuchte in der Vergussform derart fixiert wird, dass die Leuchte die Wandungen der Vergussform nicht berühren; Einbringen einer optisch-transparenten Vergussmasse in die Vergussform bis wenigstens die Leuchte umschlossen ist; Detektion einer Quantität und Qualität einer Blasenfreiheit der optisch-transparenten Vergussmasse durch einen optischen Sensor oder Bilddetektor.

Hiermit kann eine LED-Leuchte mit mindestens einer LED, mindestens einer die LED elektrisch kontaktierenden und mit Energie versorgenden Zuleitung, wobei die LED in einer Vergussmasse angeordnet ist, hergestellt werden, wobei eine LED-Verguss-Leuchten-Herstellungsvorrichtung erfindungsgemäß genutzt werden kann.

Eines der wesentlichen Probleme, welches bei optischen Inspektions- und Kartieraufgaben in der Tiefsee oder in Offshore-Bauwerksbereichen in großen Tiefen auftritt, ist die Druckfestigkeit von Leuchten mit hinreichender Ausleuchtung der zu untersuchenden Bereiche.

Die Herstellung von Leuchten, bei der wesentliche Bauteile der Leuchte miteinander einschluss- und blasenfrei vergossen werden und so nicht nur zur Stabilität der Halterung der Bauteile, sondern auch zur Bauteilereduktion, Vereinfachung der Herstellung, Verbesserung des Austauschs, der Wartungs- und Servicearbeiten, der Ausfallsicherheit und weiterer Vorteile u.a. durch die Modularität beitragen, ist für viele Fragestellungen gewünscht.

Die Anforderungen an Leuchtmittel, die unter Wasser, bei hohem Druck in großen Tiefen, auftreten, sind vielschichtig. Neben einer hohen Energieeffizienz, wird viel Wert auf eine wartungsarme, kompakte, einfache Konstruktion mit bevorzugt relativ kleiner Geometrie und kostengünstiger Fertigung gelegt. Besonders im Einsatz an Autonomen Unterwasserfahrzeugen (AUVs) spielen dabei eine hohe Lichtausbeute und möglichst kleine, leichte Bauformen eine große Rolle.

Bei klassischen Verfahren zur Herstellung von Leuchtmitteln, die für die Anwendung in der Tiefsee geeignet sind, werden bekannte geeignete Leuchten in aufwendig gefertigten eigenen Druckgehäusen untergebracht, welche groß, schwer und komplex aufgebaut sind und zudem Schwierigkeiten bei der Wärmeableitung der Leuchten aufweisen.

Für die jeweiligen Anwendungen als Blitzleuchte, Stroboskopieleuchte oder Dauerlicht sind dabei unterschiedliche Leuchtmittel mit jeweils eigenen aus den Anforderungen abgeleiteten Gehäusegeometrien bekannt, wie z.B. durch die Firma Kongsberg Maritime Ltd. In ihrer Firmenschrift: "UT2 the magazine of the society for underwater technology, Shining a Light on LEDs (Article Reprint)", January 2010, online: http://www.km.kongsberg.comlkslweblnokbg0397.nsf/AllWeb/06F29EA95A55158CC 12577040 04A2B26/$file/shininglight_viewable.pdf gezeigt.

Neben bekannten Xenon- und Quecksilberdampflampen werden, wie dort gezeigt, zunehmend auch LED-Leuchten in Druckgehäusen montiert.

Die DE 20 2008 012 002 U1 zeigt eine LED-Leuchte mit Polyurethanharz (PU) Verguss für einen Einsatz an Offshore-Windenergieanlagen mit U-förmigem Gehäuse und LEDs auf einer Leiterplatte. Die LED-Leuchte ist durch den Verguss witterungsbeständig und bietet eine gute Hafteigenschaft an den umgebenden Wandungen, in die die LED-Leuchte eingebettet ist.

Die DE 10 2012 201 447 A1 zeigt eine LED mit einer sehr dünnen Schutzschicht von 1 bis 100um, die die auf einer Leiterplatte angebrachte LED gegen Umwelteinflüsse schützen soll, ohne die optischen Eigenschaften wesentlich zu verändern.

Die DE 10 2011 106 252 A1 zeigt einen mehrteiligen Aufbau einer Leuchte mit einem vorgefertigten Leuchtenkörper mit transparentem Abschnitt als Lichtaustrittsfläche des Gehäuses und einem Leuchtmittelträger als Platine mit Kontakten und Hohlräumen, der mit einer Vergußmasse zugegossen wird und damit für den Einsatz in Feuchträumen, Kühlräumen oder explosionsgefährdeten Räumen geeignet ist.

Die DE 10 2008 009 808 A1 zeigt eine LED Lichtleiste mit konturierter Vergussmasse als ein Linsenersatz. Die LED ist auf einer Platine angebracht, die auf einem Trägermaterial aus Metall, Kunststoff oder Holz aufliegt. Die Vergussmasse bietet einen Feuchtigkeitsschutz, Schlagschutz, Kratzschutz oder Korrosionsschutz. Das Trägermaterial ragt aus der Vergussmasse heraus.

Die US 2004/0200122 A1 zeigt einen beleuchtbaren künstlichen Fischköder mit in einem Gehäuse untergebrachten LEDs, Elektronik und Batterien, der für das Meeresfischen auf Tunfische geeignet ist, die in bis zu 80m Tiefe geangelt werden.

Die JP 2008 053 545 A zeigt eine LED auf einem Trägersubstrat, welche durch Erhitzen und Schmelzen eines Glaspulvers, die LED zwischen Trägersubstrat und aufgeschmolzenem Glaspulver einschließt.

Die US 2009/0154156 A1 zeigt eine oder mehrere LEDs, die auf einem Substrat aus isolierendem Material aufgesetzt ist/sind mit leitfähigen Verbindungen und Reflektoren, die von einem optisch durchlässigen oder halbdurchlässigen Material, wie Plastik oder einem Elastomer umschlossen sind.

Die EP 2 505 906 A2 zeigt ein Verfahren zum Herstellen eines Beleuchtungskörpers auf LED-Basis als Leuchtmittel-Ersatz für eine Leuchtstoffröhre. Dabei wird ein mit mehreren LEDs bestücktes Trägerband mit Leiterbahnen und weiteren elektronischen Bauteilen auf dem Wege der Kunststoffextrusion in einen thermoplastischen Kunststoff eingebettet.

Die US 2004/0218389 A1 zeigt eine LED-Lampe für den Einsatz auf Bootstrailern/Booten mit auf einer Leiterplatte angeordneten LEDs welche von einem Biopolymer umschlossen sind, um Wasser abstoßend (water resistant) bzw. Wasser dicht (water proof) zu wirken und einen gewissen Schlagschutz zu bieten.

Die Druckschrift US 2013/0021811 A1 zeigt eine LED-Leuchte mit mindestens einer LED, mindestens einer die LED elektrisch kontaktierenden und mit Energie versorgenden Zuleitung, wobei die LED in einer Vergussmasse angeordnet ist und insbesondere mit einem LED-Leuchte-Vergussverfahren.

Die WO 2008/052667 A1 betrifft ein Verfahren zur Detektion von Fehlstellen in einem Festkörper sowie eine Vorrichtung zur Durchführung des Verfahrens. Die Beaufschlagung des Festkörpers erfolgt mit Licht von einer ersten Lichtquelle und die Detektion des bei der Beaufschlagung des Festkörpers mit dem Licht der ersten Lichtquelle erzeugten Fluoreszenzlichts. Die US20100327468 betrifft ein volumenbasiertes Abgabesteuerungsverfahren zum Abgeben von Harz, das das vorläufige Abgeben von Harz auf Werkstücken mit einer Pumpe und das Abtasten von Werkstücken durch einen optischen Scanner zum Messen des abgegebenen Harzvolumens umfasst.

Vergussverfahren für druckneutral aufgebaute LED-Leuchten die als sogenannter Vakuumverguß in einer Unterdruckkammer erfolgen sind u.a. durch das Verbundprojekt Druckneutrale Systeme (DNS) bekannt, an dem deutsche Institute und Firmen beteiligt sind (Broschüre: Maritime Erfolgsgeschichten, Forschung für Schifffahrt und Meerestechnik, PTJ-Projektträger Jülich, Dez 2012, S. 43 bis 45, FKZ: DNS 03SX220/03SX276, http://foerderportal.bund.de/foekat).

Für derartige Anwendungen ist es wichtig, den Verguss im Vakuum durchzuführen. Das gilt vor allem für mehrere Bauteile, die miteinander mit starken Hinterschneidungen oder auf sehr engem Raum gemeinsam zu vergießen sind.

Im Vergussmaterial, wie auch in kleinen Hohlräumen, beispielsweise bei Drahtwicklungen, können kleine Luftbläschen eingeschlossen sein. Diese können unter anderem die Hochspannungsfestigkeit gefährden oder Korrosion verursachen, sofern sie Feuchtigkeit mit einbringen. Um eine ausnahmslose Blasenfreiheit zu gewährleisten, muss der gesamte Aufbereitungs-, Förder- und Dosierprozess deshalb unter Vakuum durchgeführt werden.

Der Vakuumprozess ist auch ein geeignetes Verfahren, wenn es sich um feuchtigkeitsempfindliche Gießharze handelt. Die Verarbeitung unter Vakuum soll dabei unerwünschte Nebenreaktionen des Vergussmediums oder die Aufnahme von Luft ausschließen.

Wird in der Produktion von einem Vakuum gesprochen, ist eine Druckminderung in der Regel bis auf ein Millibar gemeint. Beim Verguss von elektronischen Bauteilen ist also ein reales Vakuum, also komplette Luftleere nicht notwendig.

Je weiter der Luftdruck abgesenkt wird, umso länger dauert das Evakuieren und umso mehr Energiekosten und Zeitaufwand sind damit verbunden. Aus diesem Grund wird im Stand der Technik das Vakuum gezielt auf die jeweilige Aufgabenstellung abgestimmt.

Nicht zu vernachlässigen ist dabei, dass nicht jedes Bauteil eine starke Druckreduzierung verträgt. Während ein Wickelgut weitgehend unempfindlich ist, kann die eingekapselte Luft in einem Kondensator, bei äußerem relativen Unterdruck zwischen 2 und 50 Millibar, den Kondensator zum Platzen bringen. Das bedeutet wiederum, dass sich bei Verguss mit geringeren Drücken in einem derartigen Bauteil immer noch Luftspuren befinden können, die von der Vergussmasse eingeschlossen werden.

Die am Projekt Druckneutrale Systeme (DNS) Tiefsee "Gestaltung, Umsetzung und Erprobung von druckneutralen Systemen und Einrichtungen für den Langzeitunterwasserbetrieb in Fahrzeugen und Unterwasserbauwerken in der Tiefsee" beteiligte Firma Enitech (Rostock) kam dabei zu dem Schluss, dass "... der einfache Verguss einer Baugruppe in einem gebauten Kunststoffgehäuse mit Einbettungsverguss und abschließenden Hautverguss als Membran nicht geeignet ist und nach einigen Tauchversuchen bei den meisten Baugruppen ausfiel. Nach Umstellung der Vergusstechnologie auf geschlossene Vergusssysteme mit großen Membranflächen (Tütenkonzept) konnten zuverlässige elektronische Baugruppen hergestellt und ohne Ausfälle betrieben werden." (Schriftenreihe Projektträger Jülich, ISBN 978-3-89336-922-5, S. 125 bis 129, vollständig frei verfügbar im Internet auf dem Jülicher Open Access Server (JUWEL) unter www.fz-juelich.de/zb/juwel).

Die Firma Enitech (Rostock), die sich mit dem druckneutralen Vergießen Elektronik für den Einsatz in der Tiefsee beschäftigt, zeigt z.B. einen nach diesem Verfahren hergestellten LED Scheinwerfer ENI-Light 50 (Datenblatt, Jan 2014, http://www.enitech.de/files/produkte/Datenblatt_LED.pdf).

Das angeführte Tütenkonzept umfasst eine dünnwandige feste Silikonschicht, die Tüte, in die jeweils ein Bauteil mit einer flüssigen Vergussmasse eingebracht wird. Dabei werden zum Teil auch Halte- und Trägerstrukturen mit vergossen und mit festen Deckeln versehen. Mehrere dieser Tüten können wiederum in einer Tüte zusammengefasst und gemeinsam miteinander vergossen werden.

Die angeführten Mängel des Standes der Technik werden mit dem erfinderischen Verfahren zur Herstellung von in Vergussmasse, wie z.B. PU, vergossenen Leuchten, die insbesondere LED-Leuchten für den Einsatz in der Tiefsee bereitstellen, sowie einer Vorrichtung zur Herstellung von in Vergussmasse vergossenen Leuchten, insbesondere LED-Leuchten, beseitigt.

In einer weiteren Ausführungsform bzw. Variante betrifft die Erfindung weiterhin eine spezielle UV-LED, besonders eine UV-C-LED, insbesondere für den Unterwassereinsatz als Antifouling-Mittel, die im Umfeld z.B. von Kühlwassereinlässen und/oder Sensoren den Bewuchs zumindest hemmen und damit deren Funktionalität positiv beeinflussen.

Die Herstellung derartiger UV-LED mit mindestens einer UV-C-LED als ein UV-LED Segment, bei der die Bauteile des UV-LED Segments miteinander einschluss- und blasenfrei, druckneutral vergossen werden und so nicht nur zur Stabilität der Halterung der Bauteile, sondern auch zur Bauteilereduktion, Vereinfachung der Herstellung, Verbesserung des Austauschs, der Wartungs- und Servicearbeiten, der Ausfallsicherheit und weiterer Vorteile u.a. durch die Modularität beitragen, ist für viele Fragestellungen gewünscht.

Eines der wesentlichen Probleme, welches z.B. bei einem Einsatz von Fahrzeugen, Maschinen, Bauteilen und Sensoren auf See und in Offshore-Bauwerksbereichen unter Wasser auftritt, ist der Bewuchs durch die Flora und Fauna der Meere. Dem kann durch den gezielten Einsatz von UV Licht, insbesondere UV-C begegnet werden. Ein derartiger Einsatz wird als Antifouling Maßnahme bezeichnet.

Die Anforderungen an eine erfinderische hohlraumfreie Verguss-UV-LED-Leuchte mit mindestens einer UV-C-LED für den Antifouling Einsatz, die unter Wasser eingesetzt werden, sind vielschichtig.

Neben einer hohen Energieeffizienz, wird viel Wert auf eine wartungsarme, kompakte, einfache Konstruktion mit bevorzugt relativ kleiner Geometrie und kostengünstiger Fertigung gelegt. Weiter ist eine redundante, modulare Vernetzung mehrerer derartiger erfinderischer hohlraumfreier Verguss-UV-LED-Leuchten mit mindestens einer UV-C-LED für den Antifouling Einsatz unter Wasser miteinander zur Ausfallsicherheit und Leistungsanpassung gewünscht.

Besonders im Einsatz an Bauteilen und Maschinen, wie z.B. Kühlwassereinlässen, spielen eine möglichst flexible Anpassbarkeit und/oder modulare, freie Formbarkeit, z.B. als Ring oder Teil eines Kreissektors um einen Einlass, bei gleichzeitiger hoher Lichtausbeute im Bereich eines Einlasses und möglichst kleiner Bauform eine große Rolle.

Weiter werden bei klassischen derzeit kommerziell verfügbaren UV LED "Antifoulingsystemen" werden diese als nichtintegriertes Bauteil in Metallgehäuse eingebracht und durch eine Glaskuppel geschützt.

Einen derartigen Aufbau zeigt z.B. die US 73 41 695 mit einen Antifouling Apparat für Sensoren, mit UV- Licht, Kontrollkamera und Wischer mit Druckgehäuse und einem Domeport, und die US 2014 00 78 584 A und WO 2014 / 014 779 A1 mit UV-C LEDs zur Bewuchsvermeidung auf der Oberfläche eines optisch transparenten Elements bzw. Fensters und UV-C LEDs in einem wasserdichtes Gehäuse mit UV durchlässigem Port.

Die US 46 89 523 A beschreibt ein optisches Reinigungs-System, jedoch keinen Bewuchsschutz, für die Entfernung von Substanzen auf Unterwasser-Oberflächen mit einer Hochenergie Blitzlampe vom Typ Xenon oder Krypton.

Aus der WO 2013 032 599 A1 sind eine allgemein gehaltene Methode und ein Apparat für Anti-Biofouling einer Oberfläche in flüssiger Umgebung durch UV Licht unter Einsatz von Glasfasern bekannt.

Die DE 10 2012 003 284 A1 zeigt den Einsatz von langwelligem UV Licht und sichtbarem Licht aus LED, die in einem zylinderförmigen Kunststoffkörper aus transparentem UV durchlässigen Kunststoff wie Makrolon eingegossen sind. Diese Vorrichtung ist durch die relativ geringe Wirkung des gewählten Spektrums und Materials für den speziellen Einsatz bei 12 mm Glaselektroden von ph und Redoxsensoren vorgesehen.

Der Erfindung liegt die Aufgabe zugrunde, ein einfaches und sicheres Verfahren zum blasenfreien Verguss einer LED Leuchte für den Einsatz in der Tiefsee und damit quasi auch eine LED Leuchte sowie eine Vorrichtung zur Herstellung von in Vergussmasse vergossenen Leuchten bereitzustellen, die insbesondere druckneutral bis in große Meerestiefen einsetzbar ist und die aus wenigen einzelnen Bauteilen besteht, wobei die Bauteile miteinander durch die Vergussmasse als tragendes Element gehalten werden. Ein Hauptaspekt ist hierbei der Einsatz in der Tiefsee.

Diesbezüglich kann im Weiteren mittels eines entsprechenden Herstellungsverfahrens eine Hochleistungs LED Leuchte für Unterwasser-Blitzanwendungen und/oder als Dauerlicht bereitgestellt werden.

Weiter soll auf Bauteile, wie eine Leiterplatte oder Kühlkörper verzichtet werden können, da die erfinderische LED-Leuchte trotz relativ hoher Leistung durch einen vollständigen dünnwandigen Verguss ohne Kühlkörper eine genügende Wärmeabfuhr an die Umgebung ermöglicht.

Ferner liegt der Erfindung weiterhin die Aufgabe zugrunde, ein einfaches spezielles Verfahren zur Herstellung von in Vergussmasse vergossenen Leuchten, in einem kontrollierten, möglichst blasenfreien Verguss einer hohlraumfreien Verguss-UV-LED-Leuchte mit mindestens einer UV-C-LED für den Antifouling Einsatz unter Wasser und eine Vorrichtung zur Herstellung derartiger Leuchten bereitzustellen.

Diese Aufgaben bzw. Teilaufgaben werden durch das offenbarte Verfahren und die Vorrichtung gemäß den unabhängigen Ansprüchen gelöst.

Das LED-Leuchte-Vergussverfahren insbesondere als Verfahren für eine Tiefsee-LED-Leuchte, erfolgt mit den Schritten: Konfiguration einer LED-Leuchte mit mindestens einer LED mit jeweiliger elektrisch kontaktierender Zuleitung; Einbringung der konfigurierten LED-Leuchte in eine Vergussform und Fixierung zumindest einer Zuleitung an der Vergussform, wobei zu vergießende Bauteile der LED-Leuchte die Wandungen der Vergussform nicht berühren; Verschwenken der Vergussform relativ zur Umgebung in einem Schwerkraftsystem; Einbringen einer Vergussmasse in die Vergussform bis die zu vergießenden Bauteile der LED-Leuchte vollständig mit der Vergussmasse umschlossen sind; Optische Qualitätskontrolle auf Blasenfreiheit der Vergussmasse während des Aushärtens und bedarfsweise wiederholendes Verschwenken der Vergussform, so dass innerhalb der Vergussmasse befindliche Blasen bzw. Gaseinschlüsse aus der Vergussmasse herausgefördert sind.

Das Leuchten-Vergussverfahren kann ferner mit den Schritten erfolgen: Einbringen einer konfigurierten und mit einer optisch-transparenten Vergussmasse zu vergießenden Leuchte in eine wenigstens teilweise optisch-transparente Vergussform, wobei die Vergussform in einer Vakuumkammer angeordnet ist und die Leuchte in der Vergussform derart fixiert wird, dass die Leuchte die Wandungen der Vergussform nicht berühren; Einbringen einer optisch-transparenten Vergussmasse in die Vergussform bis die Leuchte und etwaig weitere zu vergießende Bauteile der Leuchte umschlossen sind; Detektion einer Quantität und Qualität einer Blasenfreiheit der optisch-transparenten Vergussmasse durch einen optischen Sensor oder Bilddetektor, wobei eine Regelung des Druckes in der Vakuumkammer zur Beeinflussung der Blasen und/oder eine Regelung einer Schwenk-/Neigevorrichtung zur Bewegung der Vakuumkammer und der Vergussform oder der Vergussform zur Austreibung detektierter Gas-/Luftblasen aus der optisch-transparenten Vergussmasse erfolgt.

Diesbezüglich kann mittels des erfinderischen Verfahrens eine LED-Leuchte mit mindestens einer LED oder in einer speziellen Ausgestaltung auch mit einer UV-LED, mindestens einer die LED elektrisch kontaktierenden und mit Energie versorgenden Zuleitung, wobei die LED in einer Vergussmasse angeordnet ist, wobei die mindestens eine LED sowie optionale Bauteile der Tiefsee-LED-Leuchte und/oder gemeinsame oder jeweilige Träger und/oder Schnittstellen und/oder elektronische Bauteile vollständig von der Vergussmasse umschlossen sind, hergestellt werden.

Die entsprechend des erfindungsgemäßen Verfahrens hergestellte LED-Leuchte, insbesondere als Tiefsee-LED-Leuchte, weist mindestens eine LED auf, mindestens einer die LED elektrisch kontaktierenden und mit Energie versorgenden Zuleitung, wobei die LED in einer Vergussmasse angeordnet ist, wobei die mindestens eine LED sowie optionale Bauteile der Tiefsee-LED-Leuchte und/oder gemeinsame oder jeweilige Träger und/oder Schnittstellen und/oder elektronische Bauteile vollständig von der Vergussmasse umschlossen sind.

Es können weitere optionale Bauteile der LED-Leuchte und/oder gemeinsame oder jeweilige Träger und/oder Reflektor(en) und/oder Schnittstellen und/oder elektronische Bauteile vor dem Einbringen in die Vergussform kontaktiert / angeordnet / konfiguriert werden.

Das Einbringen der konfigurierten LED-Leuchte erfolgt in eine Vergussform, wobei zumindest eine Seitenfläche der Vergussform eine konvexe Geometrie aufweist.

Das Einbringen einer optisch-transparenten Vergussmasse in die Vergussform kann solange erfolgen bis zusätzliche weitere zu vergießende Bauteile der Leuchte umschlossen sind.

Das Verschwenken der Vergussform erfolgt um eine Brennachse der konkaven Ausformung der Vergussmasse, wobei eine gute Blasenableitung durch Abrollen der Blasen über den konkaven Boden erzwungen wird.

Eine Regelung des Verschwenkens der Vergussform erfolgt in Abhängigkeit von der optischen Qualitätskontrolle in Bezug auf die Blasenfreiheit der Vergussmasse.

Das Aushärten und Verschwenken erfolgt in einem Vakuum.

Eine Vielzahl von LED's können in mindestens einem LED Array angeordnet werden und über mindestens eine Zuleitung und/oder einem Bauteil zur Energieversorgung elektrisch kontaktiert und mit Energie versorgbar, wobei das mindestens eine LED-Array vollständig von der Vergussmasse umschlossen ist.

Die mindestens eine Zuleitung kann zumindest einen lackierten Draht aufweisen, der zumindest teilweise mit einem Schrumpfschlauch ummantelt ist.

Die LED-Leuchte kann mindestens einen Reflektor aufweisen, der jeweils zumindest teilweise in der Vergussmasse gehalten ist.

Zumindest eine Seitenfläche der ausgehärteten Vergussmasse der LED-Leuchte kann eine konkave Geometrie aufweisen.

Das erfinderische Verfahren zur Herstellung von in Vergussmasse vergossenen Leuchten verwendet z.B. eine oder mehrere großflächige LEDs oder LED-Arrays, welche auf einem vorzugsweise metallischen Substrat, z.B. aus Aluminium, oder Träger montiert sind mitsamt ihren Zuleitungen, passenden optionalen Reflektoren in einer dünnen Vergussmasse, z.B. Polyurethanschicht ohne Schaffung von Hohlräumen eingegossen werden und somit wasserdicht und unter Umgebungsdruck in der Tiefsee eingesetzt werden können.

Je nach technischer Ausführung können Schnittstellen und/oder Bauteile, wie Elektronikbausteine, Teil des Gießlings sein. Die Geometrie des Gießlings kann variiert werden, damit verschiedene Möglichkeiten der Befestigung und direkte Integration in eine z.B. externe, vorgegebene Struktur entstehen. Die Befestigungen können als Ausnehmungen, Zungen, Verzahnungen, Klammern, Löcher, Gewindelöcher, Gewinde, Klemmungen oder dergleichen ausgebildet werden.

Eine minimale Teileanzahl einer LED-Leuchte ist durch eine LED, z.B. Hochleistungs-LED, SMD-LED's, Zuleitung, z.B. Anschlußdrähte, und Vergußmasse bestimmt. Optional kann ein Träger für LEDs oder LED-Arrays und/oder ein Reflektor mit vergossen werden. Auf Platinen, Gehäuse und Scheiben kann verzichtet werden.

Die wenigstens eine erfindungsgemäß verfahrensgemäß hergestellte LED kann insbesondere als UV-C-LED ausgebildet werden, um für den Antifouling Einsatz ausgebildet zu sein.

Die erfindungsgemäß verfahrensgemäß hergestellte LED, LEDs oder LED-Arrays werden für den Vergussvorgang je nach Bauform mit oder ohne Träger und/oder je nach Anforderung mit oder ohne Reflektor oder Reflektoren fertig konfiguriert und nur an einem Anschlussdraht oder mehreren Anschlussdrähten der Zuleitung schwebend im Vakuum mit PU vergossen. Besonders geeignet ist die Verwendung eines mit Schrumpfschlauch ummantelten lackierten Drahtes als Anschlussdraht und Zuleitung, da dabei eine gute Haftung des PU auf dem Lack des Drahtes sichergestellt ist. Die Vergussmasse bietet an lackierten Drähten eine langfristige, mechanisch belastbare Dichtigkeit. Gleichzeitig dienen die lackierten Draht-Zuleitungen als Fixierpunkte während des Vergussvorganges und halten LED und Reflektor schwebend in der Vergussform.

Um einen möglichst blasenfreien Verguss herzustellen, wird beim erfinderischen Verfahren zur Herstellung von in Vergussmasse vergossenen Leuchten der Gießling in eine plankonkave Vergussform, bei der der Boden konkav ausgeformt ist, gegossen. Der Verguss erfolgt in relativem Vakuum in Bereichen des sogenannten Feinvakuum (1 bis 10-3 hPa). Dabei werden die detektierbaren Blasen eines Gases oder der Luft hinsichtlich der Größe beim Verguss proportional zur Erhöhung des relativen Vakuums kleiner bzw. bei Verringerung des relativen Vakuum größer.

Dieser Effekt wird ausgenutzt, um während des Vergussvorgangs eine gute Blasenableitung durch Abrollen der Blasen über den konkaven Boden zu erzwingen, indem die Vergussform um die Brennachse der konkaven Ausformung des Bodens verschwenkt wird.

Die Kontrolle der Qualität der Blasenfreiheit wird auf optischem Wege, bevorzugt bzw. insbesondere über ein Sensorsystem überprüft bzw. erfasst.

In Abhängigkeit von der optischen Prüfung erfolgt die Regelung der Verschwenkung der Vergussform.

Verguss-Leuchten-Herstellungsvorrichtung mit: einer Vakuumkammer, einer wenigstens teilweise optisch-transparenten Vergussform zur Aufnahme einer mit einer optisch-transparenten Vergussmasse zu vergießenden Leuchte, einer Druckmesseinrichtung mit einer Druckregelung für den Druck innerhalb der Vakuumkammer, einem Bilddetektor zur Detektion von Gas-/Luftblasen innerhalb der wenigstens teilweise optisch-transparenten Vergussform, eine Schwenk-/Neigevorrichtung zum direkten oder indirekten Schwenken und Neigen der wenigstens teilweise optisch-transparenten Vergussform durch Verschwenken und/oder Neigen der wenigstens teilweise optisch-transparenten Vergussform oder der Vakuumkammer, einer Auswerte-, Speicherungs- und Regelungseinheit zur Regelung der Schwenk-/Neigevorrichtung und/oder des Druckes innerhalb der Vakuumkammer.

Der Bilddetektor ist als aktiver Sensor, als Kamera ausgebildet und bevorzugt durch eine Lichtquelle für Gegenlicht bei einer Durchleuchtung unterstützbar.

Die Vakuumkammer ist wenigstens teilweise optisch-transparent ausgebildet, so dass der Bilddetektor außerhalb der Vakuumkammer anordenbar ist.

Ein Zufuhrmittel ist zur Zuführung einer optisch-transparenten Vergussmasse vorgesehen.

Die Schwenk-/Neigevorrichtung ist innerhalb der Vakuumkammer zum ausschließlichen Verschwenken der wenigstens teilweise optisch-transparenten Vergussform angeordnet.

Die wenigstens teilweise optisch-transparente Vergussform ist vollständig optisch-transparent ausgebildet.

Wenigstens eine Seite der wenigstens teilweise optisch-transparenten Vergussform weist eine konkave Geometrie auf.

Die Herstellung von waagerechten Flächen unter Bauteilen in geringer Schichtstärke durch Verguss, selbst im Vakuum, ist bekanntermaßen schwierig, wie durch den Stand der Technik hinreichend belegt. Bei nur teilvergossenen Bauteilen wie beispielsweise Reflektoren von Leuchten sind waagerechte Flächen jedoch oft unvermeidbar.

Da Blasen im Verguss insbesondere bei hohen Druckunterschieden zwischen Leuchte und Umgebung, wie z.B. bei Tiefseeanwendungen unerwünscht sind, geringe Schichtstärken jedoch für die Wärmeabfuhr z.B. von LEDs bzw. speziellen LEDs erforderlich sind wurde das erfinderische Verfahren und die erfinderische Vorrichtung zur Herstellung von in Vergussmasse vergossenen Leuchten entwickelt.

Eine weitere Aufgabe bei der Herstellung solcher dünnwandig vergossener Leuchten ist es, möglichst wenig Ausschuss zu produzieren.

Daher muss der Prozess des Vergusses durch eine Regelung die Qualität des Vergussvorganges unterstützen. Voraussetzung für die Beobachtbarkeit ist eine transparente Vakuumkammer bzw. ein Vakuumkammer in der optische Beobachtungen, z.B. durch Fenster, durchführbar sind. Weiter ist eine transparente Vergussform sowie eine transparente Vergussmasse erforderlich, die eine optische Kontrolle ermöglicht. Hilfsmaßnahmen, wie eine zusätzliche Durchleuchtung, z.B. intensives Gegenlicht für einen optischen Sensor, können die Detektion von Blasen in der Vergussmasse erleichtern.

Um diese an waagerechten Flächen unterhalb des Vergussgutes gefangenen Blasen auszutreiben wird in dieser Vorrichtung eine Schwenk- oder Neige Vorrichtung sowie eine besonders ausgeformte Vergussform verwendet. Weiter wird die Blasengröße mit einem regelbaren variablen Unterdruck in der Kammer beeinflusst. Dadurch ist eine Automatisierung auch für die Herstellung größere Stückzahlen möglich. Dabei wird vorzugsweise ein Bildsensor für die optische Kontrolle eingesetzt, der insbesondere Rechner gestützt in einem Regelmodul eine Auswertung, Speicherung durchführt und eine Schwenk-Neigevorrichtung entsprechend regelt und die Bewegung der Blase oder der Blasen verfolgt. Gegebenenfalls kann das Vakuum variiert werden bzw. dabei geregelt ein erneuter Zyklus expandieren-evakuieren gestartet werden.

Nach Austreiben der Blase/n ist der Vorgang beendet und es kann drucktechnisch expandiert werden.

Durch den Verguss sind alle elektrischen Teile isoliert und es bleiben keine Hohlräume, welche unter Druck zu strukturellen Belastungen, Aufreißen des Vergusses und Undichtigkeiten mit folgender Korrosion führen könnten. Der Reflektor der LED wird mit eingegossen. Innerhalb des Reflektors ist die LED lediglich mit einer dünnen PU Schicht überzogen, sodass sich nur geringe Änderungen der Abstrahlcharakteristik unter Wasser in Bezug auf die Anwendung an Luft ergeben. Der dünne Verguss des LED Trägers oder Substrats sorgt innerhalb hinreichend definierter Toleranzen im Unterwasserbetrieb für eine ausreichende Kühlung. Durch die komplette Ummantelung mit PU, ist die Schockfestigkeit und Korrosionsbeständigkeit der gesamten Einheit weiter erhöht. Da dadurch auch keine Metalloberfläche Kontakt zur Umgebung hat, sind Korrosion und elektrochemische Vorgänge unterbunden.

Durch das Fehlen von Druckkörpern sind die einzelnen LED-Leuchten sehr leicht und erzeugen nur wenig Abtrieb unter Wasser. Daher wird ihr Einsatz auf Tauchrobotern von der Stückzahl her lediglich durch die bereitstellbare Energieversorgung und den Einbauraum, weniger jedoch durch ihr Gewicht begrenzt.

Da die erfindungsgemäß verfahrensgemäß hergestellte LED Leuchte üblicher Weise nur für relativ kurze Zeit (einige Millisekunden) in einem Blitzbetrieb eingesetzt wird, bei dem energiereiche Blitze über kürzere Intervalle abgegeben werden, können in dieser Betriebsart deutlich höhere Ströme fließen als im Dauerbetrieb der LED Leuchte. Dabei ist die Auswahl der Leistung einer LED nur durch die Substrats- bzw. Trägerfläche sowie eine Mindestschichtdicke der Vergussmasse mit bekannter abführbarer Verlustleistung (Wärme) durch die PU Masse begrenzt.

Die LED Leuchte kann durch das Herstellungsverfahren einfach an die Erfordernisse angepasst werden, indem z.B. die jeweilige LED an die Beleuchtungsanforderungen angepasst wird.

Durch Bestimmung der Farbtemperatur einer zu verbauenden LED in der LED Leuchte wird z.B. eine Anpassung des Lichtspektrums in Abhängigkeit der zu erwartenden Distanz der Ausleuchtung unter Wasser erreicht.

Eine Änderung der Richtcharakteristik ist durch die Wahl geeigneter Reflektoren möglich, wobei auch gängige Reflektoren aus Kunststoffen genutzt werden können. Mit einer gezielten Formung der Geometrie des Reflektors, ist die Erzeugung eines definierten Lichtkegels unter Wasser erreichbar.

Die Anwendungsgebiete für eine erfinderische LED Leuchte im Tiefseebereich an jegliche Art von Unterwasserrobotern, z.B. ROV, AUV, hängenden Sonden oder an und in autonomen Meeresbodenobservatorien, ist sehr vielseitig.

Neben dem Einsatz als Blitz-Array zur Fotografie und für stroboskopische Zeitlupenaufnahmen von Gasaustritten am Meeresboden ist die LED Leuchte als Arbeitsleuchte im Dauerbetrieb einsetzbar.

Aufgrund der einfachen kostengünstigen Herstellung und dem geringen Gewicht der einzelnen Einheiten ist die Anwendung sehr gut skalierbar hin zu sehr starken Beleuchtungsanlagen. Gleichzeitig werden hohe Einsparungen beim Energiebedarf durch eine stroboskopische Ansteuerung möglich. Im Gegensatz zu Xenonblitzlampen erlauben LEDs sehr hohe Wiederholraten, was entscheidend für eine lückenlose Abdeckung bei Fotokartierungen des Meeresbodens sein kann und Hochgeschwindigkeitsblitzen bei Videoanwendungen erlaubt.

Eine weitere Aufgabe ist die frei wählbare Geometrie der erfinderischen hohlraumfreien Verguss-UV-LED-Leuchte mit mindestens einer UV-C-LED für den Antifouling Einsatz unter Wasser und damit die Anpassung an Oberflächen in durch Antifouling gefährdeten Bereichen oder Zonen zu ermöglichen, wie z.B. freie formbare Ringe oder modulare Segmente z.B. für Kühlwassereinlässe oder exponierte Sensoren oder Fühlerkuppeln die in das funktionelle Design eine Oberfläche nicht oder nur sehr wenig eingreifen. Durch die funktionelle Anpassung der erfinderischen hohlraumfreie Verguss-UV-LED-Leuchte mit mindestens einer UV-C-LED für den Antifouling Einsatz unter Wasser sind z.B. Arrays für Schwinger und Sensor-Netze für größere Flächenmessungen einfach zu versorgen. Ähnliches kann auch für Standard LEDs im Sinne dieser Offenbarung sinnvoll sein, wobei sich dies auch auf die im Weiteren folgenden Aspekte bezieht.

Eine Befestigung der erfinderischen hohlraumfreien Verguss-UV-LED-Leuchte mit mindestens einer UV-C-LED für den Antifouling Einsatz unter Wasser kann einfach durch in die Vergussmasse der Verguss-UV-LED-Leuchte eingegossene Magnete, Buchsen, Gewindebuchsen und/oder Kugelköpfe ermöglicht werden, wobei die Buchsen, Gewinde oder Koppelungseinrichtungen in der Vergussmasse ausformbar sind.

Die erforderliche Elektronik wird dabei mit der UV-LED mit mindestens einer UV-C-LED integrierbar eingegossen. Dies gilt auch für ein Quarzglasfenster das für optische Transmission geeignet ist. Auf Leiterplatten oder Kühlkörper kann bei der erfinderischen hohlraumfreien Verguss-UV-LED-Leuchte verzichtet werden, da selbst bei hohen Leistungen eine gute Wärmeabfuhr durch den relativ dünnwandigen Vergusskörper an das umgebende Wasser erfolgt.

Der Einbau von zusätzlichen LEDs mit farbigem sichtbarem Licht, die Anzeige- und Kontrollfunktionen, z.B. für eine Aktivanzeige zur Kontrolle der UV-C LED für einen Nutzer bieten ist ebenfalls möglich. Durch den integrierten Einbau derartiger LEDs im sichtbaren Spektrum, die über den gleichen Abstrahlwinkel, wie die UV-C LED verfügen, ist eine einfache Abschätzung und Einstellung des Lichtkegel/Wirkungsradius der gesamten Einheit möglich. Dabei können auch bekannte, standardisierte Reflektoren Verwendung finden und ganz oder Teilweise mit vergossen werden. Wobei durch den Verguss eine zur Lichtquelle relative Fixierung erfolgt.

Beim Aufbau der hohlraumfreien Verguss-UV-LED-Leuchte wird der Kontakt von Wasser mit Metalloberflächen im Verguss unmöglich und dadurch eine Korrosion oder elektrochemische Reaktion durch Wasser vermieden.

Die geringe Teileanzahl, die im Wesentlichen aus LED, einem Reflektor, einem Quarzglasfenster, einer Zuleitung oder internen Energieversorgung und der Vergussmasse bestehen, ermöglicht eine einfache, leichte, kompakte, individuell an die Umgebung anpassbare Bauweise. Dabei sind für den Designer der erfinderischen hohlraumfreien Verguss-UV-LED-Leuchte auch Konzepte, wie "form follows funktion" umsetzbar.

Optional kann der Aufbau der erfinderischen hohlraumfreien Verguss-UV-LED-Leuchte auch neben der UV-C-LED weitere LED aufnehmen, die in unterschiedlichen spektralen Bereichen, auch im sichtbaren Bereich, emittieren, um z.B. die Funktion eine Kontroll LED und/oder Wirkungsbereich LED zu übernehmen. Dadurch wird die Einstellung, Fixierung und Überprüfung bei der Installation erleichtert.

Ein Träger für die LED ist nicht zwingend vorgesehen, kann aber z.B. als Positionierungshilfe beim Aufbau vor dem Verguss dienen. In der Regel werden die Bauteile der erfinderischen hohlraumfreien Verguss-UV-LED-Leuchte schwebend an der Zuleitung oder an Anschlußdrähten gehalten und im Vakuum mit PU vergossen.

Um einen blasenfreien Verguß und damit eine hohlraumfreien Verguss-UV-LED-Leuchte herzustellen, kann der Gießling über eine besondere Ausbildung des Vergußformbodens verfügen, der eine geregelte Blasenableitung durch Verschwenken des Gießlings ermöglicht, die durch eine Kontrolle, z.B. im Gegenlicht überwachbar ist.

Die Zuleitungen, die beim Vergießen als Träger wirken, bestehen bevorzugt aus einem Kupferlackdraht mit Schrumpfschlauch anstelle normaler isolierter Litze, da PU über gute Haftungseigenschaften auf dem Lack des Drahtes verfügen. Eine Energieversorgung der hohlraumfreien Verguss-UV-LED-Leuchte gestaltet sich relativ einfach und erfolgt entweder extern über die Zuleitung oder intern. Da die wesentliche aktive Baugruppe in der hohlraumfreien Verguss-UV-LED-Leuchte die verwendete UV-C LED ist, die eine relativ geringe Leistungsaufnahme maximal im Bereich weniger Watt hat, ist eine externe Versorgung nicht zwingend erforderlich, sondern kann intern realisiert werden. Damit ist die Entscheidung für eine reine externe Energieversorgung der hohlraumfreien Verguss-UV-LED-Leuchte über eine Zuleitung eher davon abhängig, ob bereits eine gut erreichbare Energieversorgung im Bereich der Anwendung vorhanden ist und auch die vor Bewuchs zu schützenden aktiven Sensoren eine dauerhafte Energieversorgung benötigen, die die hohlraumfreien Verguss-UV-LED-Leuchte mit speisen kann. Die hohlraumfreie Verguss-UV-LED-Leuchte kann, auch grundsätzlich, eine eigene Energieversorgung, z.B. Batterie/Akku statt oder ergänzend zu einer Zuleitung aufweisen. Die Entscheidung für eine solche Variante der hohlraumfreien Verguss-UV-LED-Leuchte ist von erforderlicher Laufzeit und der Leistung abhängig.

Es kann wenigstens ein Quarzglasfenster in Abstrahlrichtung der UV-C-LED vorgesehen sein.

Eine weitere Alternative der Energieversorgung für die hohlraumfreie Verguss-UV-LED-Leuchte sowie die LED-Version ist über eine drahtlose Energieübertragung möglich, z.B. induktiv. Dabei wird in der hohlraumfreien Verguss-LED-/UV-LED-Leuchte eine induktive Schnittstelle eingesetzt, welche mit einer externen induktiven Schnittstelle korrespondiert, die z.B. im zu schützenden Objekt verbaut ist.

Eine weitere Alternative der Energieversorgung für die hohlraumfreie Verguss-UV-LED-Leuchte als auch für die LED-Variante ist über energy harvesting möglich. Dies kann je nach Einsatzgebiet z.B. die Erzeugung elektrischer Energie aus Temperaturdifferenzen oder durch Strömung im umgebenden Wasser erfolgen.

Die verschiedenen Baugruppen der hohlraumfreien Verguss-UV-LED-Leuchte können in einer weiteren Variante auch als einzelne austauschbare vergossene Module gefertigt und verbaut werden. Die Vergusstechnik erlaubt eine weitreichende Formfreiheit und Anpassbarkeit an verschiedenste Geometrien. Eines der Module kann dabei z.B. aus der -UV-C-LED mit Träger und Zuleitung bestehen. Die Kontroll LED und/oder Wirkungsbereich LED oder Wirkungsbereichskontrolle kann in einem eigenen Modul optional verbaut werden und muss nicht zwingend dauerhaft Teil der hohlraumfreien Verguss-UV-LED-Leuchte sein. Die Überprüfung des Betriebszustandes und der Wirkungsradiusabschätzung der hohlraumfreien Verguss-UV-LED-Leuchte kann auch durch mit geführte Messgeräte erfolgen, die nur zeitweise an die hohlraumfreien Verguss-UV-LED-Leuchte angekoppelt werden.

Die Elektronik der hohlraumfreien Verguss-UV-LED-Leuchte übernimmt die erforderliche Spannungskonvertierung und Bereitstellung der Konstantstromquelle für eine oder mehrere LED, sowie eine zeitgesteuerte Taktung.

Das erfinderische Verfahren zur Herstellung von in Vergussmasse vergossenen hohlraumfreien Verguss-UV-LED-Leuchten mit je mindestens einer UV-C-LED für den Antifouling Einsatz unter Wasser verwendet z.B. eine oder mehrere großflächige UV-C-LED oder LED-Arrays, welche auf einem vorzugsweise metallischen Substrat, z.B. aus Aluminium, oder Träger montiert sind mitsamt ihren Zuleitungen, passenden optionalen Reflektoren in einer dünnen Vergussmasse aus Polyurethan ohne Schaffung von Hohlräumen eingegossen werden und somit wasserdicht und unter Umgebungsdruck in der Tiefsee eingesetzt werden können.

Je nach technischer Ausführung können Schnittstellen und/oder Bauteile, wie Elektronikbausteine, Teil des Gießlings sein. Die Geometrie des Gießlings kann variiert werden, damit verschiedene Möglichkeiten der Befestigung und direkte Integration in eine z.B. externe, vorgegebene Struktur entstehen. Die Befestigungen können als Ausnehmungen, Zungen, Verzahnungen, Klammern, Löcher, Gewindelöcher, Gewinde, Klemmungen oder dergleichen ausgebildet werden.

Die LED, LEDs oder LED-Arrays als UV-C-LED werden für den Vergussvorgang je nach Bauform mit oder ohne Träger und/oder je nach Anforderung mit oder ohne Reflektor oder Reflektoren fertig konfiguriert und nur an einer Zuleitung, einem Anschlussdraht oder mehreren Anschlussdrähten der Zuleitung schwebend im Vakuum mit PU vergossen. Besonders geeignet ist die Verwendung eines mit Schrumpfschlauch ummantelten lackierten Drahtes als Anschlussdraht und Zuleitung, da dabei eine gute Haftung des PU auf dem Lack des Drahtes sichergestellt ist. Die Vergussmasse bietet an lackierten Drähten eine langfristige, mechanisch belastbare Dichtigkeit. Gleichzeitig dienen die lackierten Draht-Zuleitungen als Fixierpunkte während des Vergussvorganges und halten LED und Reflektor schwebend in der Vergussform.

Das Verfahren zur Herstellung der hohlraumfreien Verguss-UV-LED-Leuchte Polyurethan (PU), kann mit den Schritten erfolgen: Einbringen einer konfigurierten und mit einer optisch-transparenten Vergussmasse aus Polyurethan (PU) zu vergießenden Leuchte in eine wenigstens teilweise optisch-transparente Vergussform, wobei die Vergussform in einer Vakuumkammer angeordnet ist und die Leuchte in der Vergussform derart fixiert wird, dass die Leuchte die Wandungen der Vergussform nicht berühren; Einbringen einer optisch-transparenten Vergussmasse in die Vergussform bis die Leuchte und etwaig weitere zu vergießende Bauteile der Leuchte umschlossen sind; Detektion einer Quantität und Qualität einer Blasenfreiheit der optisch-transparenten Vergussmasse durch einen optischen Sensor oder Bilddetektor, wobei eine Regelung des Druckes in der Vakuumkammer zur Beeinflussung der Blasen und/oder eine Regelung einer Schwenk-/Neigevorrichtung zur Bewegung der Vakuumkammer und/oder der Vergussform zur Austreibung detektierter Gas-/Luftblasen aus der optisch-transparenten Vergussmasse erfolgt.

Ferner kann die Verguss-Leuchten-Herstellungsvorrichtung ausgestaltet werden, mit: einer Vakuumkammer, einer wenigstens teilweise optisch-transparenten Vergussform zur Aufnahme einer mit einer optisch-transparenten Vergussmasse zu vergießenden Leuchte, einer Druckmesseinrichtung mit einer Druckregelung für den Druck innerhalb der Vakuumkammer, einem Bilddetektor zur Detektion von Gas-/Luftblasen innerhalb der wenigstens teilweise optisch-transparenten Vergussform, eine Schwenk/Neigevorrichtung zum direkten oder indirekten Schwenken und Neigen der wenigstens teilweise optisch-transparenten Vergussform durch Verschwenken und/oder Neigen der wenigstens teilweise optisch-transparenten Vergussform oder der Vakuumkammer, einer Auswerte-, Speicherungs- und Regelungseinheit zur Regelung der Schwenk-/Neigevorrichtung und/oder des Druckes innerhalb der Vakuumkammer.

Das erfinderische Verfahren kann beispielsweise zumindest eine UV-C-LE, optional weitere LEDs oder LED-Arrays, verwenden, welche frei an zumindest einer Zuleitung oder auf einem vorzugsweise metallischen Substrat, z.B. aus Aluminium, oder Träger montiert sind mitsamt ihren Zuleitungen, passenden optionalen Reflektoren in einer Vergussmasse aus Polyurethan (PU) ohne Schaffung von Hohlräumen eingegossen werden und somit wasserdicht und unter Umgebungsdruck in der Tiefsee eingesetzt werden können.

Weitere Vorteile, Merkmale und Anwendungsmöglichkeiten der vorliegenden Erfindung ergeben sich aus der nachfolgenden Beschreibung in Zusammenhang mit den Figuren.

Es zeigen:
- Fig. 1: eine erfindungsgemäß hergestellte LED-Leuchte mit einem LED auf einem Träger mit Reflektor in Seitenansicht und in Aufsicht;
- Fig. 2: eine erfindungsgemäß hergestellte LED-Leuchte mit einem LED auf einem Träger in Seitenansicht und in Aufsicht;
- Fig. 3: eine erfindungsgemäß hergestellte LED-Leuchte mit einem LED-Array mit LEDs jeweils auf einem Träger in Seitenansicht und in Aufsicht;
- Fig. 4: eine erfindungsgemäß hergestellte LED-Leuchte mit einem LED auf einem Träger mit Schnittstelle bzw. elektronischem Baustein und Reflektor in Seitenansicht und in Aufsicht;
- Fig. 5: eine erfindungsgemäß hergestellte LED-Leuchte mit einem LED-Array mit LEDs jeweils auf einem Träger in Seitenansicht und in Aufsicht in einer weiteren Variante;
- Fig. 6: eine erfindungsgemäß hergestellte LED-Leuchte mit einem LED auf einem Träger mit Reflektor in Seitenansicht und plankonkaver Geometrie der Vergussmasse;
- Fig. 7: eine Vorrichtung zur Herstellung von in Vergussmasse vergossenen erfindungsgemäß hergestellten Leuchten;
- Fig. 8: eine erste Ausführungsform einer erfindungsgemäß hergestellten LED-Leuchte mit einer UV-LED für den Antifouling-Unterwassereinsatz;
- Fig 9: eine zweite Ausführungsform einer erfindungsgemäß hergestellten LED-Leuchte mit einer UV-LED für den Antifouling-Unterwassereinsatz und
- Fig 10: eine dritte Ausführungsform einer erfindungsgemäß hergestellten LED-Leuchte mit einer UV-LED für den Antifouling-Unterwassereinsatz.

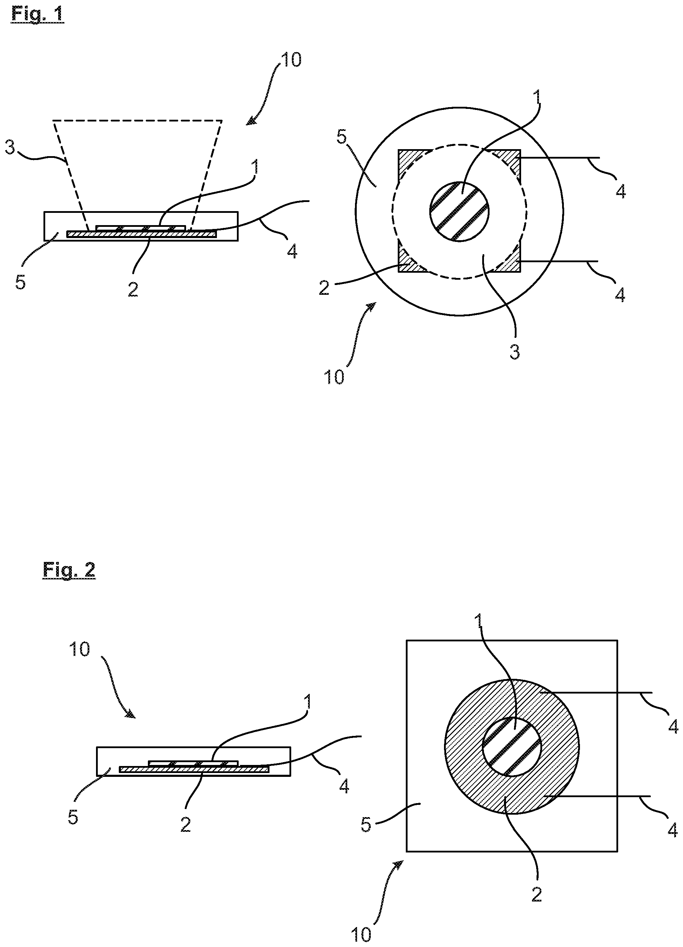

Figur 1 zeigt beispielhaft eine erfindungsgemäß hergestellte LED-Leuchte (10) mit einer LED (1) auf einem Träger (2) mit Reflektor (3) in Seitenansicht und in Aufsicht. Die LED (1) ist auf einem metallischen Träger (2), z.B. aus Aluminium fixiert, z.B. verklebt. Auf den Träger (2) ist ein Reflektor (3) gestellt, der die LED (1) umfasst und eine trichterförmige Fokussierung der Beleuchtungsrichtung ermöglicht. Am Träger ist jeweils eine Zuleitung (4) befestigt, z.B. verlötet, gesteckt oder gecrimpt, die die LED (1) elektrisch kontaktieren und die Energieversorgung sicherstellen. Die Vergussmasse (5) ist als dünne kreisförmige Scheibe ausgeformt, die die LED (1) und den Träger (2) vollständig einschließt. Der Reflektor (3) und die Zuleitungen (4) sind nur zum Teil vergossen.

Figur 2 zeigt beispielhaft eine erfindungsgemäß hergestellte LED-Leuchte (10) mit einer LED (1) auf einem Träger (2) in Seitenansicht und in Aufsicht. Die LED (1) ist auf einem metallischen Träger (2) fixiert. Am Träger ist jeweils eine Zuleitung (4) befestigt, z.B. verlötet, die die LED (1) elektrisch kontaktieren und die Energieversorgung sicherstellen. Die Vergussmasse (5) ist als dünne rechteckige Platte ausgeformt, die die LED (1) und den Träger (2) vollständig einschließt. Die Zuleitungen (4) sind nur zum Teil vergossen.

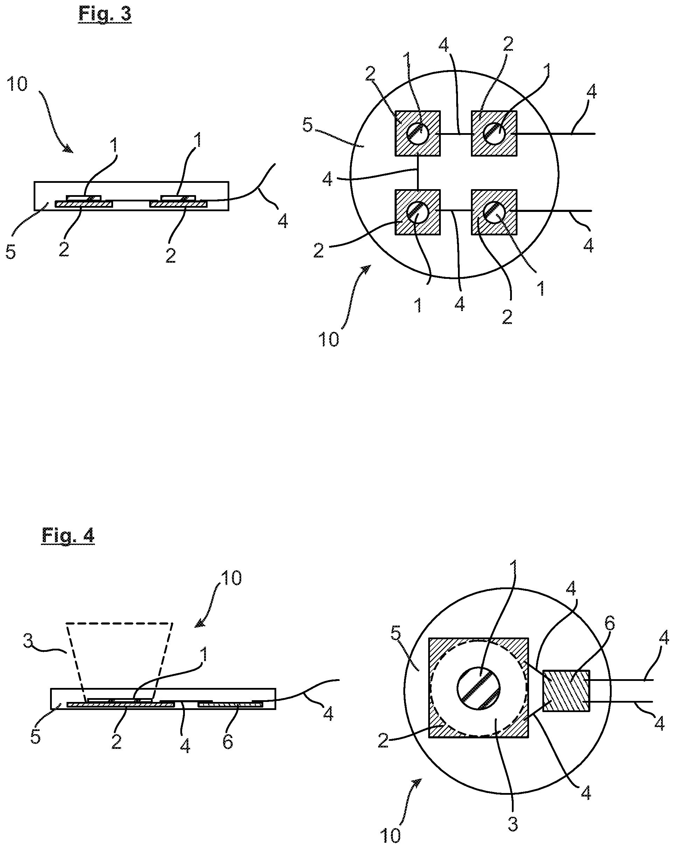

Figur 3 zeigt beispielhaft eine erfindungsgemäß hergestellte LED-Leuchte (10) mit einem LED-Array aus vier Einzel-LEDs (1) jeweils auf einem Träger (2) in Seitenansicht und in Aufsicht. Die jeweilige LED (1) des LED-Arrays ist auf einem metallischen Träger (2) fixiert. Die Träger (2) sind in Serie durch Zuleitungen (4) miteinander, die LEDs (1) elektrisch kontaktierend, verbunden. Die Vergussmasse (5) ist als dünne kreisförmige Scheibe ausgeformt, die die LEDs (1), die Zwischenverbindungen als Zuleitungen (4) zwischen den einzelnen LEDs (1) des LED Arrays und die Träger (2) vollständig einschließt. Die weiteren Zuleitungen (4) sind nur zum Teil vergossen.

Figur 4 zeigt beispielhaft eine erfindungsgemäß hergestellte LED-Leuchte (10) mit einer LED (1) auf einem Träger (2) und einer Schnittstelle/Bauteil (6) in Seitenansicht und in Aufsicht. Die LED (1) ist auf einem metallischen Träger (2) fixiert. Der Träger (2) ist parallel durch Zuleitungen (4) mit einer Schnittstelle bzw. einem elektronischen Baustein, die LED (1) elektrisch kontaktierend, verbunden. Die Vergussmasse (5) ist als dünne kreisförmige Scheibe ausgeformt, die die LED (1) und die Zwischenverbindungen als Zuleitungen (4) zwischen der LED (1), der Schnittstelle bzw. dem elektronischen Baustein und dem Träger (2) vollständig einschließt. Die weiteren Zuleitungen (4) sind nur zum Teil vergossen.

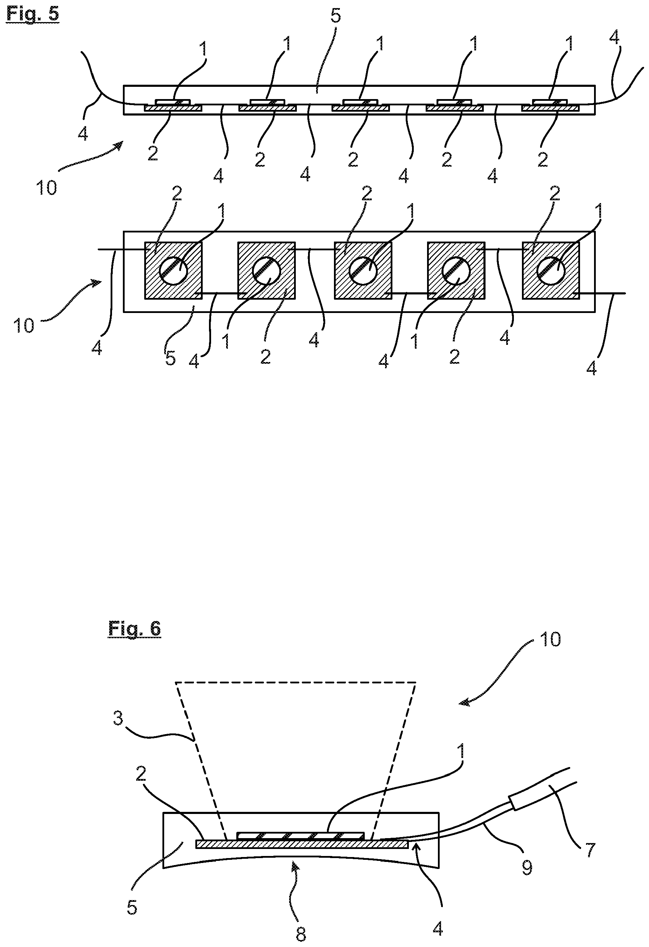

Figur 5 zeigt beispielhaft eine erfindungsgemäß hergestellte LED-Leuchte (10) mit einem LED-Array aus fünf Einzel-LEDs (1) jeweils auf einem Träger (2) in Seitenansicht und in Aufsicht. Die jeweilige LED (1) des LED-Arrays ist auf einem metallischen Träger (2) fixiert. Die Träger (2) sind in Serie durch Zuleitungen (4) miteinander, die LEDs (1) elektrisch kontaktierend, verbunden. Die Vergussmasse (5) ist als dünne rechteckige Platte ausgeformt, die die LEDs (1), die Zwischenverbindungen als Zuleitungen (4) zwischen den einzelnen LEDs (1) des LED Arrays und die Träger (2) vollständig einschließt. Die weiteren Zuleitungen (4) sind nur zum Teil vergossen.

Figur 6 zeigt beispielhaft eine erfindungsgemäß hergestellte LED-Leuchte (10) mit einer LED (1) auf einem Träger (2) mit Reflektor (3) in Seitenansicht. Die LED (1) ist auf einem metallischen Träger (2) fixiert. Auf den Träger (2) ist ein Reflektor (3) gestellt, der die LED (1) umfasst und eine trichterförmige Fokussierung der Beleuchtungsrichtung ermöglicht. Am Träger ist eine Zuleitung (4) befestigt, die einen mit Lack beschichteten Draht (9) aufweist, der auf dem Träger (2) fixiert ist, z.B. verlötet, und die LED (1) elektrisch kontaktiert und von einem Schrumpfschlauch (7) umschlossen ist. Die Vergussmasse (5) ist als dünne plankonkave Scheibe ausgeformt, die die LED (1) und den Träger (2) vollständig einschließt. Der Reflektor (3) und die Zuleitungen (4) sind nur zum Teil vergossen.

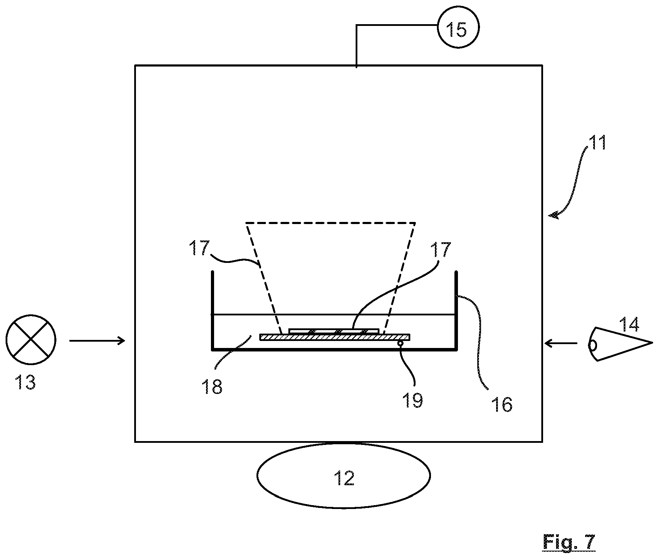

Figur 7 zeigt beispielhaft eine erfinderische Vorrichtung zur Herstellung von in Vergussmasse vergossenen Leuchten. In einer optisch transparenten Vakuumkammer (11), die auch teilweise optisch transparent oder mit einem Fenster versehen sein kann, ist in einer optisch transparenten Vergussform (16) eine Leuchte, hier beispielhaft eine LED mit Reflektor (17) und nicht gezeigten Zuleitungen (4) frei gehalten. Eine optisch transparente Vergussmasse (18) umschließt die LED mit Reflektor (17), wobei der Reflektor aus der optisch transparenten Vergussmasse (18) herausragt. Durch eine Druckmesseinrichtung (5) kann eine Druckregelung überwacht werden, mit der die Luftblasengröße einer Luftblase (9) in der optisch transparenten Vergussmasse (18) beeinflussbar ist. Die Luftblase (9) wird über einen Bilddetektor (14) detektiert, der durch die optisch transparente Vakuumkammer (11) und die optisch transparenten Vergussform (16) in der optisch transparenten Vergussmasse (18) einen Status von Blasen (9) quantitativ und qualitativ erfasst und an eine nicht gezeigte Auswerte-, Speicherungs- und Regelungseinheit weitergibt. Durch diese Regelungseinheit wird eine Schwenk-/Neigevorrichtung (12) in ihrer Bewegung geregelt, die die optisch transparenten Vakuumkammer (11) bzw. die optisch transparenten Vergussform (16) derart bewegt, dass die Luftblasen (9) aus der optisch transparente Vergussmasse (18) ausgetrieben werden. Der Bilddetektor kann dabei aktiv betrieben werden und auch durch einen geeignete Lichtquelle für Gegenlicht (13) unterstützt werden.

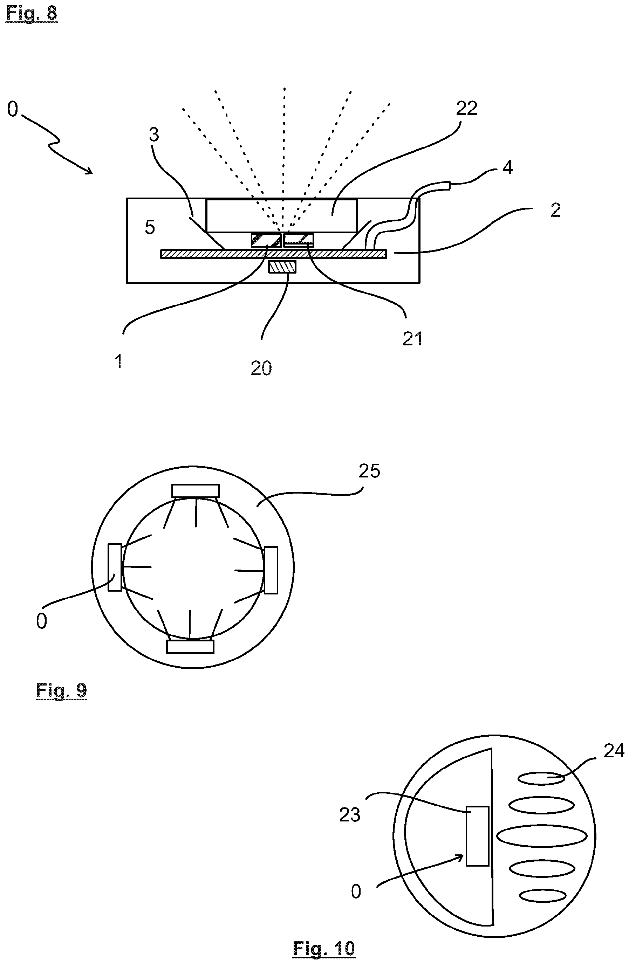

In Figur 8 ist eine erste Ausführungsform einer erfindungsgemäß hergestellten LED-Leuchte mit einer UV-LED für den Antifouling-Unterwassereinsatz dargestellt.

Es wird auf die zuvor dargestellten Ausführungen im Allgemeinen verwiesen. Hierbei ist eine UV-LED 1 auf einem Träger 2 aufgebracht. Zusätzlich ist auf diesem Träger 2 eine Kontroll-LED 20 und eine Wirkungsbereich-LED 21 angeorndet, um den Wirkungsbereich zu erkennen bzw. die Funktion zu kontrollieren. Ferner ist noch zusätzlich ein Quarzglasfenster 22 angeordnet. Diese Einheit wird als LED-Leuchtensegment 0 bezeichnet.

Figur 9 zeigt eine zweite Ausführungsform einer erfindungsgemäß hergestellten LED-Leuchte mit einer UV-LED für den Antifouling-Unterwassereinsatz.

Es ist eine Röhre 25 dargestellt, bei der vier UV-LED-Leuchten 0 die Röhre freihalten, wodurch ein Antifouling realisiert wird.

Figur 10 beschreibt eine dritte Ausführungsform einer erfindungsgemäß hergestellten LED-Leuchte mit einer UV-LED für den Antifouling-Unterwassereinsatz.

Hierbei ist ein Kühlwassereinlass 24 gezeigt, wobei ein UV-LED-Leuchtensegment 0 die Einlässe frei hält. Das LED-Leuchtensegment 0 weist eine integrierte Elektronik mit Konstantstromversorgung und einer Taktung 23 auf.

### Bezugszeichenliste

- 0: LED-Leuchtsegment
- 1: LED, UV-LED, UV-C-LED
- 2: Träger
- 3: Reflektor
- 4: Zuleitung
- 5: Vergussmasse
- 6: Schnittstelle bzw. elektronisches Bauteil
- 7: Schrumpfschlauch
- 8: Konkaver Boden
- 9: Lackierter Draht
- 10: LED Leuchte
- 11: optisch transparente Vakuumkammer
- 12: Schwenk-/ Neigevorrichtung
- 13: Lichtquelle für Gegenlicht
- 14: Bilddetektor
- 15: Druckmesseinrichtung
- 16: optisch transparente Vergussform
- 17: LED mit Reflektor
- 18: optisch transparente Vergussmasse
- 19: Luftblase
- 20: Kontroll LED
- 21: Wirkungsbereich LED
- 22: Quarzglasfenster
- 23: Elektronik mit Konstantstromversorgung und/oder Taktung
- 24: Kühlwassereinlass
- 25: Röhre

## Patentansprüche

1. LED-Leuchte-Vergussverfahren mit den Schritten:
- Einbringen einer konfigurierten und mit einer optisch-transparenten Vergussmasse zu vergießenden Leuchte in eine wenigstens teilweise optisch-transparente Vergussform (16), wobei die Vergussform (16) in einer Vakuumkammer (11) angeordnet ist und die Leuchte in der Vergussform (16) derart fixiert wird, dass die Leuchte die Wandungen der Vergussform nicht berühren;
- Einbringen einer optisch-transparenten Vergussmasse (18) in die Vergussform (16) bis wenigstens die Leuchte umschlossen ist;
- Detektion einer Quantität und Qualität einer Blasenfreiheit der optisch-transparenten Vergussmasse (18) durch einen optischen Sensor oder Bilddetektor (14),
wobei
- eine Regelung des Druckes in der Vakuumkammer (11) zur Beeinflussung der Blasen und/oder
- eine Regelung einer Schwenk-/Neigevorrichtung (12) zur Bewegung der Vakuumkammer (11) und der Vergussform (16) oder der Vergussform zur Austreibung detektierter Gas-/Luftblasen (19) aus der optisch-transparenten Vergussmasse (18) erfolgt.

2. LED-Leuchte-Vergussverfahren nach Anspruch 1,
**dadurch gekennzeichnet, dass**
das Einbringen einer optisch-transparenten Vergussmasse (18) in die Vergussform (16) solange erfolgt bis zusätzliche weitere zu vergießende Bauteile der Leuchte umschlossen sind.

3. LED-Leuchte-Vergussverfahren nach Anspruch 1 oder 2,
**dadurch gekennzeichnet, dass**
weitere optionale Bauteile der LED-Leuchte und/oder gemeinsame oder jeweilige Träger und/oder Reflektor(en) und/oder Schnittstellen und/oder elektronische Bauteile vor dem Einbringen in die Vergussform kontaktiert / angeordnet / konfiguriert werden.

4. LED-Leuchte-Vergussverfahren nach Anspruch 1, 2 oder 3,
**dadurch gekennzeichnet, dass**
das Einbringen der konfigurierten LED-Leuchte in eine Vergussform erfolgt, wobei zumindest eine Seitenfläche der Vergussform eine konvexe Geometrie aufweist und das Verschwenken der Vergussform um eine Brennachse der konkaven Ausformung der Vergussmasse erfolgt, wobei eine gute Blasenableitung durch Abrollen der Blasen über den konkaven Boden erzwungen wird.

5. LED-Verguss-Leuchten-Herstellungsvorrichtung mit:
- einer Vakuumkammer (11),
- einer wenigstens teilweise optisch-transparenten Vergussform (16) zur Aufnahme einer mit einer optisch-transparenten Vergussmasse zu vergießenden Leuchte,
- einer Druckmesseinrichtung (15) mit einer Druckregelung für den Druck innerhalb der Vakuumkammer (11),
- einem Bilddetektor (14) zur Detektion von Gas-/Luftblasen innerhalb der wenigstens teilweise optisch-transparenten Vergussform (16),
- eine Schwenk-/Neigevorrichtung (12) zum direkten oder indirekten Schwenken und Neigen der wenigstens teilweise optisch-transparenten Vergussform (16) durch Verschwenken und/oder Neigen der wenigstens teilweise optisch-transparenten Vergussform (16) oder der Vakuumkammer (11) und der Vergussform,
- einer Auswerte-, Speicherungs- und Regelungseinheit zur Regelung der Schwenk-/Neigevorrichtung (12) und/oder des Druckes innerhalb der Vakuumkammer (11).

6. LED-Verguss-Leuchten-Herstellungsvorrichtung nach dem vorangehenden Anspruch,
**dadurch gekennzeichnet, dass**
der Bilddetektor als aktiver Sensor, als Kamera ausgebildet ist,
bevorzugt durch eine Lichtquelle für Gegenlicht (13) bei einer Durchleuchtung unterstützbar ist.

7. LED-Verguss-Leuchten-Herstellungsvorrichtung nach einem der zwei vorangehenden Ansprüche,
**dadurch gekennzeichnet, dass**
die Vakuumkammer (11) wenigstens teilweise optisch-transparent ausgebildet ist, so dass der Bilddetektor außerhalb der Vakuumkammer (11) anordenbar ist.

8. Verguss-Leuchten-Herstellungsvorrichtung nach einem der drei vorangehenden Ansprüche,
**dadurch gekennzeichnet, dass**
die Schwenk-/Neigevorrichtung (12) innerhalb der Vakuumkammer zum ausschließlichen Verschwenken der wenigstens teilweise optisch-transparenten Vergussform (16) angeordnet ist.

9. Verguss-Leuchten-Herstellungsvorrichtung nach einem der vier vorangehenden Ansprüche,
**dadurch gekennzeichnet, dass**
die wenigstens teilweise optisch-transparente Vergussform (16) vollständig optisch-transparent ausgebildet ist
und/oder
wenigstens eine Seite der wenigstens teilweise optisch-transparenten Vergussform (16) eine konkave Geometrie aufweist.

## Claims

1. LED lamp potting method comprising the steps of:
- introducing a configured lamp to be potted using an optically transparent potting compound into an at least partly optically transparent potting mould (16), wherein the potting mould (16) is arranged in a vacuum chamber (11) and the lamp is secured in the potting mould (16) such that the lamp does not touch the walls of the potting mould;
- introducing an optically transparent potting compound (18) into the potting mould (16) until at least the lamp is enclosed;
- detecting a quantity and quality of the absence of bubbles in the optically transparent potting compound (18) by means of an optical sensor or image detector (14),
wherein
- the pressure in the vacuum chamber (11) is controlled to influence the bubbles and/or
- a pivoting/tilting device (12) for moving either the vacuum chamber (11) and the potting mould (16) or the potting mould is controlled to expel detected gas/air bubbles (19) from the optically transparent potting compound (18).

2. LED lamp potting method according to claim 1,
**characterised in that**
an optically transparent potting compound (18) is introduced into the potting mould (16) until such a time as additional lamp components to be potted are enclosed.

3. LED lamp potting method according to either claim 1 or claim 2,
**characterised in that**
additional optional components of the LED lamp and/or common or respective carriers and/or reflector(s) and/or interfaces and/or electronic components are contacted/arranged/configured prior to introduction into the potting mould.

4. LED lamp potting method according to claim 1, 2 or 3,
**characterised in that**
the configured LED lamp is introduced into a potting mould, at least one side face of the potting mould having a convex geometry and the potting mould being pivoted about a focal axis of the concave moulding of the potting mould, good discharge of bubbles being forced by rolling the bubbles over the concave bottom.

5. LED potted lamp production device comprising:
- a vacuum chamber (11),
- an at least partly optically transparent potting mould (16) for receiving a lamp to be potted using an optically transparent potting compound,
- a pressure measurement apparatus (15) comprising pressure control for the pressure within the vacuum chamber (11),
- an image detector (14) for detecting gas/air bubbles within the at least partly optically transparent potting mould (16),
- a pivoting/tilting device (12) for directly or indirectly pivoting and tilting the at least partly optically transparent potting mould (16) by pivoting and/or tilting either the at least partly optical transparent potting mould (16) or the vacuum chamber (11) and the potting mould,
- an evaluation, storage and control unit for controlling the pivoting/tilting device (12) and/or the pressure within the vacuum chamber (11).

6. LED potted lamp production device according to the preceding claim,
**characterised in that**
the image detector is configured as an active sensor, in the form of a camera, and preferably can be assisted by a light source for backlighting (13) for transillumination.

7. LED potted lamp production device according to any of the two preceding claims,
**characterised in that**
the vacuum chamber (11) is configured to be at least partly optically transparent such that the image detector can be arranged outside the vacuum chamber (11).

8. Potted lamp production device according to any of the three preceding claims,
**characterised in that**
the pivoting/tilting device (12) is arranged within the vacuum chamber for pivoting only the at least partly optically transparent potting mould (16).

9. Potted lamp production device according to any of the four preceding claims,
**characterised in that**
the at least partly optically transparent potting mould (16) is configured to be completely optically transparent
and/or
at least one side of the at least partly optically transparent potting mould (16) has a concave geometry.

## Revendications

1. Procédé d'enrobage de lampes à DEL avec les étapes consistant à :
- Introduire dans un moule d'enrobage au moins partiellement transparent optiquement (16) une lampe configurée et à enrober avec une masse d'enrobage ransparente optiquement, le moule d'enrobage (16) étant disposé dans une chambre à vide (11) et la lampe étant fixée dans le moule d'enrobage (16) de telle sorte que la lampe ne touche pas les parois du moule d'enrobage ;
- Introduire une masse d'enrobage transparente optiquement (18) dans le moule d'enrobage (16) jusqu'à ce qu'au moins la lampe soit entourée ;
- Détecter par un capteur optique ou un détecteur d'images (14) une quantité et une qualité en termes d'absence de bulles de la masse d'enrobage transparente optiquement (18),
avec
- réalisation d'une régulation de la pression dans la chambre à vide (11) pour influencer les bulles, et/ou
- réalisation d'une régulation d'un dispositif de basculement et d'inclinaison (12) pour déplacer la chambre à vide (11) et le moule d'enrobage (16) ou le moule d'enrobage en vue d'expulser de la masse d'enrobage transparente optiquement (18) des bulles de gaz/air (19) détectées est commandé.

2. Procédé d'enrobage de lampes à DEL selon la revendication 1, **caractérisé en ce que** l'introduction d'une masse d'enrobage transparente optiquement (18) dans le moule d'enrobage (16) se poursuit jusqu'à ce que des composants supplémentaires également à enrober soient entourés.

3. Procédé d'enrobage de lampes à DEL selon la revendication 1 ou 2, **caractérisé en ce que** d'autres composants optionnels de la lampe DEL et/ou des supports communs ou respectifs et/ou un ou des réflecteurs et/ou des interfaces et/ou des composants électroniques sont contactés/disposés/configurés avant leur introduction dans le moule d'enrobage.

4. Procédé d'enrobage de lampes à DEL selon la revendication 1, 2 ou 3, **caractérisé en ce que** l'introduction de la lampe à DEL configurée dans un moule d'enrobage est réalisée, au moins une surface latérale du moule d'enrobage présente une géométrie convexe et le moule d'enrobage est pivoté autour d'un axe focal de la forme concave de la masse d'enrobage, une bonne évacuation des bulles étant forcée en faisant rouler les bulles sur la base concaves.

5. Dispositif de fabrication de lampes à DEL enrobées avec :
- une chambre à vide (11),
- un moule d'enrobage au moins partiellement transparent optiquement (16) pour recevoir une lampe à enrober avec une masse d'enrobage transparente optiquement,
- un dispositif de mesure de pression (15) avec une commande de pression pour la pression à l'intérieur de la chambre à vide (11),
- un détecteur d'images (14) pour détecter des bulles de gaz/air à l'intérieur du moule d'enrobage au moins partiellement transparent optiquement (16),
- un dispositif de basculement et d'inclinaison (12) pour faire basculer et incliner directement ou indirectement le moule d'enrobage au moins partiellement transparent optiquement (16) en faisant basculer et/ou en inclinant le moule d'enrobage au moins partiellement transparent optiquement (16) ou la chambre à vide (11) et le moule d'enrobage,
- une unité d'évaluation, de stockage et de commande pour réguler le dispositif de basculement et d'inclinaison (12) et/ou la pression à l'intérieur de la chambre à vide (11).

6. Dispositif de fabrication de lampes à DEL enrobées selon la revendication précédente, **caractérisé en ce que** le détecteur d'images est conçu sous la forme d'un capteur actif, sous la forme d'une caméra, de préférence pouvant être appuyé par une source lumineuse pour rétroéclairage (13) lors d'un mirage.

7. Dispositif de fabrication de lampes à DEL enrobées selon l'une des deux revendications précédentes, **caractérisé en ce que** la chambre à vide (11) est conçue au moins partiellement transparente optiquement, de sorte que le détecteur d'images peut être disposé à l'extérieur de la chambre à vide (11).

8. Dispositif de fabrication de lampes enrobées selon l'une des trois revendications précédentes, **caractérisé en ce que** le dispositif de pivotement et d'inclinaison (12) est disposé à l'intérieur de la chambre à vide en vue de faire pivoter exclusivement le moule d'enrobage au moins partiellement transparent optiquement (16).

9. Dispositif de fabrication de lampes enrobées selon l'une des quatre revendications précédentes, **caractérisé en ce que** le moule d'enrobage au moins partiellement transparent optiquement (16) est totalement transparent optiquement et/ou au moins un côté du moule d'enrobage au moins partiellement transparent optiquement (16) a une géométrie concave.
